# EUROPÄISCHE PATENTSCHRIFT

(11) **EP 0 623 689 B1**
(45) Veröffentlichungstag und Bekanntmachung des Hinweises auf die Patenterteilung: **20.10.1999**
(21) Anmeldenummer: 94106574.0
(22) Anmeldetag: 27.04.1994
(51) Int. Cl.: C23C 14/04, C23C 14/50, G11B 7/26

(54) **Trägerpalette für Substrate von optischen Speichern**
Carrier for optical recording substrates
Porte-substrats pour substrats destinés à l'enregistrement optique

(30) Priorität: 05.05.1993 DE 9306789 U
(43) Veröffentlichungstag der Anmeldung: 09.11.1994
(73) Patentinhaber: HOECHST AKTIENGESELLSCHAFT, 65926 Frankfurt am Main (DE)
(72) Erfinder: Weber, Christoph, Dr. Dipl.-Phys., D-63303 Dreieich (DE); Schmidt, Günther, Dr. Dipl.-Phys., D-65527 Niedernhausen (DE); Fries, Hartwig, Dipl.-Ing., D-47533 Kleve (DE); Küper, Stephan, Dr. Dipl.-Chem., D-65232 Taunusstein (DE)
(74) Vertreter: Zounek, Nikolai, Dipl.-Ing.

(56) Entgegenhaltungen:
- EP-A- 0 006 475
- PATENT ABSTRACTS OF JAPAN vol. 15, no. 11 (P-1150) 10. Januar 1991 & JP-A-02 254 645 (CANON) 15. Oktober 1990
- PATENT ABSTRACTS OF JAPAN vol. 13, no. 187 (C-592) 2. Mai 1989 & JP-A-01 011 972 (SEIKO EPSON CORP) 17. Januar 1989

## Beschreibung

Die Erfindung betrifft eine Vorrichtung aus Trägerpalette und Masken zum Beschichten von Substraten optischer Speichermedien durch Targetzerstäubung, mit einer Anzahl von kreisförmigen Einsenkungen in der Trägerpalette zur Aufnahme der Substrate.

Bei bekannten Trägerpaletten werden die Substrate von Speichermedien, wie optischen und magentooptischen Speicherplatten, auf die eine Aufzeichnungsschicht aufgesputtert werden soll, auf die Palette aufgelegt, die dann durch die Vakuum-Sputteranlage hindurchgeführt wird. Dabei liegen die Substrate der Speicherplatten mit ihrer Unterseite bündig auf der Oberfläche der Trägerpalette auf, so daß die Kanten der Substrate frei liegen. Dadurch sind die Kanten der Substrate den in der Sputteranlage auftretenden Plasmen in der Hochspannungsentladung während der Zerstäubung mehrerer Targets schutzlos ausgesetzt, was dazu führt, daß die Plasmen bzw. die in den Plasmen entstehende UV-Strahlung zu einem Abbau der Oberfläche der Substrate, die im allgemeinen aus Polymeren bestehen, führt. Nach dem Aufsputtern der Aufzeichnungsschichten auf die Substrate erfolgt als anschließender Arbeitsgang das Aufbringen einer UV-Schutzlackschicht auf die fertigen Speicherplatten. Dabei ergibt sich der Nachteil, daß die Kanten der Substrate infolge der Plasmaeinflüsse bzw. der Einwirkung der UV-Strahlung in den Plasmen eine modifizierte Oberfläche aufweisen, was eine geringere Haftung der UV-Schutzlackschicht als auf der sonstigen Oberfläche der Speicherplatten mit sich bringt. Dadurch wird die Klimastabilität der Speicherplatten stark beeinträchtigt, da der UV-Schutzlack von den Kanten der Speicherplatten nach einer gewissen Zeit absplittert und die Lacksplitter sowohl das Einschreiben von Daten als auch das Auslesen der Daten erheblich stören, was im Gebrauch zu Datenverlusten führen kann.

Aus der EP-A-0 006 475 ist eine Vorrichtung zur Beschichtung von Werkstücken durch Kathodenzerstäubung bekannt, insbesondere von als kreisförmige Wafer ausgebildeten Halbleiterstrukturen, die durch Anordnung in Vertiefungen einer Trägerplatte mit regelmäßigen gegenseitigen Abständen in Form eines konzentrischen Musters an der Oberfläche einer Anodenplatte einer Entladungskammer aufgelegt sind. Die Vertiefungen der Trägerplatte gehen in Teilbereichen eines Waferumfangs über den Umfang eines Wafers hinaus und weisen in radialer Richtung sich erstreckende Vertiefungserweiterungen auf. Randabdeckungen der Wafer durch Masken sind nicht vorhanden.

Das Dokument Patent Abstracts of Japan. Vol. 15, No. 11, (P-1150) offenbart einen Substrathalter als Aufspannvorrichtung, in der eine äußere periphere Maske und eine innere periphere Maske die Ränder eines Substrats festklemmen. Diese Masken dienen in erster Linie dazu, das Substrat vor dem Beschichten in dem Substrathalter zu krümmen, indem sie den Rand des zentralen Substratloches bzw. den äußeren Rand des Substrats festhalten, wobei die Ränder in zwei voneinander beabstandeten Ebenen aufliegen. Es soll dadurch die Streifenbildung in den Schichten während des Aufsputterns dieser Schichten auf das Substrat verringert werden, indem das Substrat vor dem Beschichten um einen vorgegebenen Betrag in Richtung entgegengesetzt zu der mechanischen Spannung der zusammengesetzten Schichten gekrümmt wird. Durch diese Art der Fertigung sollen bei den hergestellten magnetooptischen Aufzeichnungsmedien in Gestalt von Speicherplatten Risse und Brüche der aufgesputterten Schichten auf dem Substrat, bedingt durch äußere Belastungen, wie Temperaturänderungen, vermieden werden.

Aufgabe der Erfindung ist die Ränder von optischen Speichermedien, wie Speicherplatten, gegen die Einflüsse des Plasmas während des Sputterns abzuschirmen und die Klimastabilität der Speicherplatten zu verbessern, und das Absplittern von Lackschichten von den Kanten bzw. Rändern der Speicherplatten auszuschließen.

Diese Aufgabe wird erfindungsgemäß dadurch gelöst, daß in jeder der Einsenkungen eine zentrale Auflage für das Substrat vorhanden ist und daß eine Maske flächig auf der Trägerpalette aufliegt und korrespondierend mit den Einsenkungen kreisförmiger Ausnehmungen aufweist, deren Durchmesser kleiner als die Durchmesser der Einsenkungen sind.

In Ausgestaltung der Erfindung stehen weitere Masken mit T-förmigem Querschnitt mit den Auflagen in Kontakt, liegen bündig auf den Substraten auf und decken ein Mittelloch jedes Substrats ab.

In Weitergestaltung der Erfindung besitzt ein Querteil der Maske einen Durchmesser größer als ein Durchmesser der Auflage. Ferner ist ein Durchmesser eines Senkrechtteils der Maske kleiner als ein Durchmesser der Auflage.

Da die Substrate während des Sputtervorgangs in den Einsenkungen der Trägerpalette untergebracht sind und die Ränder bzw. Kanten der Speicherplatten durch eine Maske während des Sputtervorgangs abgedeckt sind, werden die Kanten der Substrate gegenüber Plasmaeinflüssen weitgehend abgeschirmt, so daß die Polymeroberfläche der Kanten nicht durch das Einwirken der Plasmen verändert werden kann. Dadurch besitzen die Kanten der fertigen Speicherplatten das gleiche Haftvermögen für einen UV-Schutzlack wie die übrigen Oberflächen der Speicherplatten.

Die Erfindung wird im folgenden anhand eines zeichnerisch dargestellten Ausführungsbeispiels näher erläutert. Es zeigen:
- Figur 1: eine Draufsicht auf eine Trägerpalette nach der Erfindung teilweise aufgebrochen, und
- Figur 2: einen Schnitt durch eine Einsenkung der Trägerpalette, entlang der Linie I-I in Figur 1, im vergrößerten Maßstab.

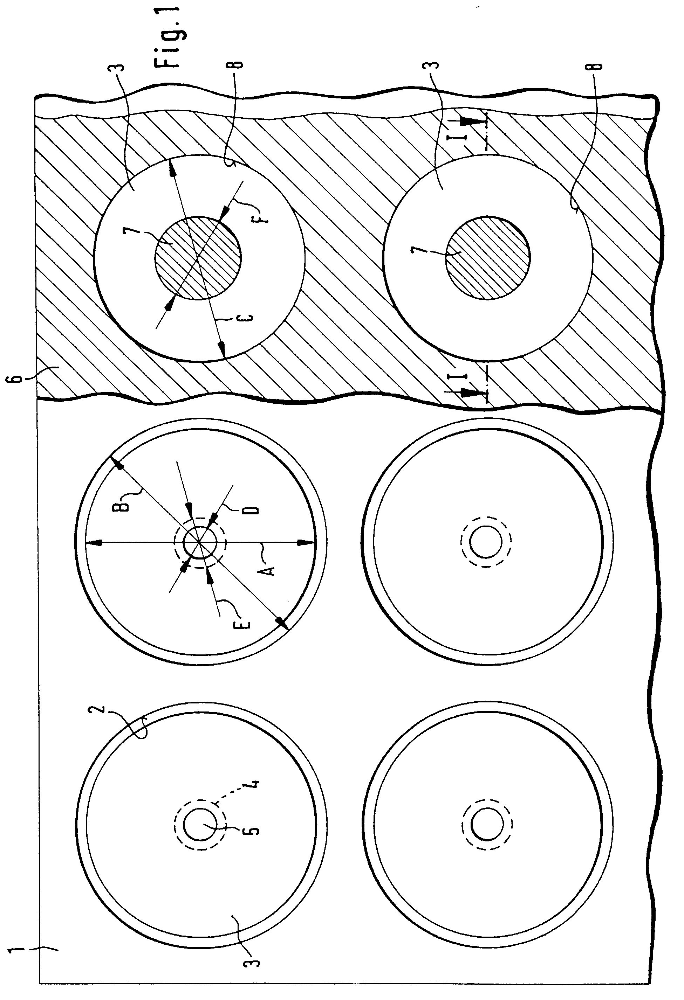

Wie aus Figur 1 ersichtlich ist, sind in einer Trägerpalette 1 reihen- und spaltenweise Einsenkungen 2 vorhanden, in denen Substrate 3 angeordnet sind, die in einer Vakuum-Sputteranlage mit einer Aufzeichnungsschicht beschichtet werden. Jedes Substrat 3 besitzt ein Mittelloch 5. Der nicht-schraffierte linke Bereich der Figur 1 zeigt die Trägerpalette 1 mit den in den Einsenkungen 2 eingelegten Substraten 3 ohne Abdeckung durch entsprechende Masken. Das Mittelloch 5 hat einen Durchmesser D, der kleiner als ein Durchmesser E einer Auflage 5 ist, die in der Mitte der Einsenkung 2 angeordnet ist und deren Rand gestrichelt dargestellt ist. Ein Durchmesser B der Einsenkung 2 ist größer als ein Durchmesser A des Substrats 3.

Im schraffierten rechten Bereich der Figur 1 sind die von einer durchgehenden Maske 6 an ihren Außenrändern abgedeckten Substrate 3 gezeigt. Die Maske 6 liegt flächig auf der Trägerpalette 1 auf und weist, korrespondierend mit den Einsenkungen 2, kreisförmige Ausnehmungen 8 mit einem Durchmesser C auf, der kleiner als der Durchmesser A der Substrate 3 ist. Die Differenz zwischen den Durchmessern A und C beträgt 1 bis 6 mm, d.h. mit anderen Worten, daß der Rand jedes Substrats 3 0,5 bis 3 mm von der Maske 6 abgedeckt ist.

Die Substrate 3 haben eine Dicke von 1 bis 1,5 mm, insbesondere von 1,2 mm, und können Durchmesser von 2 1/2, 3 1/2, 5 1/4 Zoll oder 12 Zoll aufweisen. Die Trägerpalette 1 kann in Abhängigkeit von dem Durchmesser der Substrate eine bestimmte Anzahl von Substraten aufnehmen.

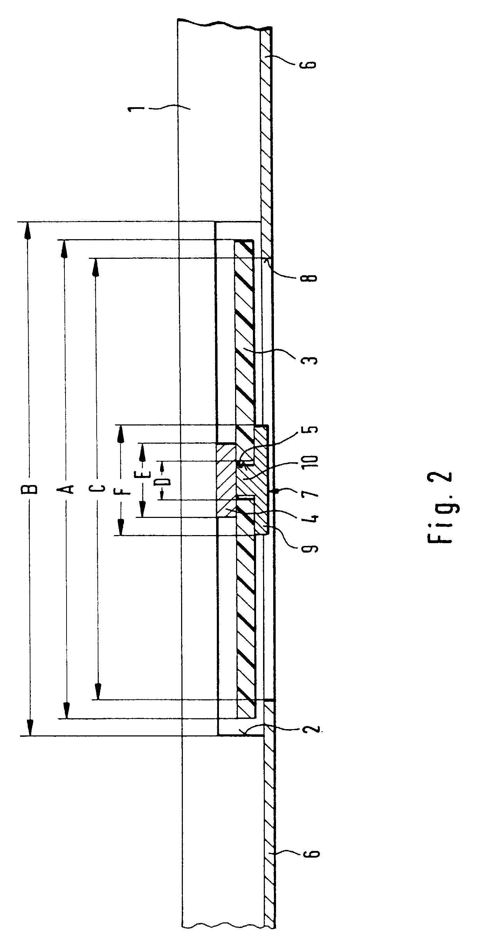

Figur 2 zeigt einen Schnitt entlang der Linie I-I einer Einsenkung 2 der Figur 1. Neben der Maske 6 ist noch eine weitere Maske 7 vorhanden, die die Kanten bzw. Ränder des Mittellochs 5 des Substrats 3 gegen die Plasmaeinflüsse während der Sputterbeschichtung schützt. Das Substrat 3 liegt auf der zentralen Auflage 4 auf. Die Tiefe der Einsenkung 2 ist etwa 0 bis 4 mm größer als die Dicke des Substrats 3. In das Mittelloch 5 ist die Maske 7 mit T-förmigem Querschnitt eingesetzt, wobei der Querteil 9 der Maske 7 einen größeren Durchmesser F besitzt als der Senkrechtteil 10 der Maske 7, der das Mittelloch 5 ausfüllt. Der Durchmesser F des Querteils 9 der Maske 7 ist seinerseits größer als der Durchmesser D des Mittellochs 5 im Substrat 3. Die Maske 7 liegt bündig auf der Substratoberfläche auf und stellt sicher, daß die Ränder bzw. Kanten des Mittellochs 5 abgedeckt sind. Ebenso stellt die Auflage 4 sicher, daß das Mittelloch 5, von der Rückseite des Substrats 3 her gesehen, voll abgedeckt ist. Somit liegt das Substrat 3 während der Sputterbeschichtung in der Einsenkung 2 auf der Auflage 4 auf und wird von der Maske 6, entlang dem Außenrand, und von der weiteren Maske 7 in bezug auf das Mittelloch 5 gegen die Plasmaeinflüsse geschützt.

Optische und magnetooptische Speicherplatten, die während des Sputterns in eine derartige Trägerpalette 1 eingebracht sind, und nach dem Aufsputtern der Aufzeichnungsschicht mit einem UV-Schutzlack beschichtet werden, zeigen eine deutlich verbesserte Klimastabilität. Bei einem Hochtemperatur-Hochfeucht-Klimatest kommt es bei derartigen Speicherplatten auch nach 1000 Stunden nicht zu einem Absplittern des UV-Schutzlackes von dem Substrat 3.

## Patentansprüche

1. Vorrichtung aus Trägerpalette und Masken zum Beschichten von Substraten optischer Speichermedien durch Targetzerstäubung, mit einer Anzahl von kreisförmigen Einsenkungen in der Trägerpalette zur Aufnahme der Substrate, dadurch gekennzeichnet, daß in jeder der Einsenkungen (2) eine zentrale Auflage (4) für das Substrat (3) vorhanden ist und daß eine Maske (6) flächig auf der Trägerpalette (1) aufliegt und korrespondierend mit den Einsenkungen (2) kreisförmige Ausnehmungen (8) aufweist, deren Durchmesser (C) kleiner als die Durchmesser (B) der Einsenkungen (2) sind.

2. Vorrichtung nach Anspruch 1, dadurch gekennzeichnet, daß weitere Masken (7) mit T-förmigem Querschnitt mit den Auflagen (4) in Kontakt stehen, bündig auf den Substraten (3) aufliegen und ein Mittelloch (5) jedes Substrats (3) abdecken.

3. Vorrichtung nach Anspruch 2, dadurch gekennzeichnet, daß ein Querteil (9) der Maske (7) einen Durchmesser (F) größer als ein Durchmesser (E) der Auflage (4) besitzt.

4. Vorrichtung nach Anspruch 2, dadurch gekennzeichnet, daß ein Durchmesser eines Senkrechtteils (10) der Maske (7) kleiner als ein Durchmesser (E) der Auflage (4) ist.

## Claims

1. Device comprising a carrier palette and masks for coating substrates of optical storage media by sputtering a target, with a number of circular depressions in the carrier palette, in which depressions the substrates are disposed, characterized in that each one of the depressions (2) exhibits a central overlay (4) on which the substrate (3) rests and that a mask (6) rests flat on the carrier palette (1) and, corresponding to the depressions (2), exhibits circular recesses (8) having a diameter (C) smaller than the diameter (B) of the depressions (2).

2. Device as claimed in claim 1, characterized in that further masks (7) of T-shaped cross-section are in contact with the overlays (4), flushly rest onto the substrates (3) and cover over a central hole (5) of each substrate (3).

3. Device as claimed in claim 2, charactrized in that a transverse part (9) of the mask (7) has a diameter (F) greater than a diameter (E) of the overlay (4).

4. Device as claimed in claim 2, characterized in that a diameter of a vertical part (10) of the mask (7) is smaller than a diameter (E) of the overlay (4).

## Revendications

1. Dispositif pour le couchage de substrats de médiums de mémoire optiques par atomisation sur une cible, constitué par une palette de support et des masques, avec un certain nombre de creusures circulaires situées dans la palette de support pour le logement des substrats, caractérisé en ce qu'il est prévu dans chacune des creusures (2) un appui central (4) pour le substrat (3), et en ce qu'un masque (6) s'appuie en nappe contre la palette de support (1) et présente des évidements (8) circulaires qui correspondent avec les creusures (2), évidements dont les diamètres (C) sont plus petits que les diamètres (B) des creusures (2).

2. Dispositif selon la revendication 1, caractérisé en ce que d'autres masques (7) présentant une section en forme de T, sont en contact avec les appuis (4), s'appuient à plat contre les substrats (3) et recouvrent un trou central (5) de chaque substrat (3).

3. Dispositif selon la revendication 2, caractérisé en ce qu'une partie transversale (9) du masque (7) présente un diamètre (F) plus grand qu'un diamètre (E) de l'appui (4).

4. Dispositif selon la revendication 2, caractérisé en ce qu'un diamètre d'une partie verticale (10) du masque (7) est plus petit qu'un diamètre (E) de l'appui (4).
